(19) Europäisches Patentamt
European Patent Office
Office européen des brevets

(11) **EP 2 118 942 B1**

(12) **FASCICULE DE BREVET EUROPEEN**

(45) Date de publication et mention de la délivrance du brevet:
**24.10.2012 Bulletin 2012/43**

(51) Int Cl.:
*H01L 41/113* *(2006.01)* *H01L 31/058* *(2006.01)*
*H02N 2/18* *(2006.01)*

(21) Numéro de dépôt: **08708791.2**

(22) Date de dépôt: **07.02.2008**

(86) Numéro de dépôt international:
**PCT/EP2008/051512**

(87) Numéro de publication internationale:
**WO 2008/101814 (28.08.2008 Gazette 2008/35)**

(54) **DISPOSITIF DE CONVERSION D'ÉNERGIE MÉCANIQUE D'IMPACTS EN ÉNERGIE ÉLECTRIQUE À RENDEMENT OPTIMISÉ**

VORRICHTUNG ZUR UMWANDLUNG DER MECHANISCHEN ENERGIE VON EINSCHLÄGEN IN ELEKTRISCHE ENERGIE MIT OPTIMIERTEM ERTRAG

DEVICE FOR CONVERTING THE MECHANICAL ENERGY OF IMPACTS INTO ELECTRIC ENERGY WITH AN OPTIMISED YIELD

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **08.02.2007 FR 0753151**

(43) Date de publication de la demande:
**18.11.2009 Bulletin 2009/47**

(73) Titulaire: **Commissariat à l'Énergie Atomique et aux Énergies Alternatives 75015 Paris (FR)**

(72) Inventeurs:
• **JAGER, Thomas**
  **F-38000 Grenoble (FR)**
• **CHAILLOUT, Jean-Jacques**
  **F-38960 Saint-Etienne-de-Crossey (FR)**
• **DESPESSE, Ghislain**
  **F-38120 Saint Egreve (FR)**
• **GUIGON, Romain**
  **F-38380 Miribel-les-Echelles (FR)**

(74) Mandataire: **Ilgart, Jean-Christophe et al BREVALEX 95 rue d'Amsterdam 75378 Paris Cedex 8 (FR)**

(56) Documents cités:
EP-A- 1 394 868          WO-A-00/13582
DE-A1- 3 935 807         DE-A1- 19 831 692
FR-A- 2 544 074          US-A- 4 404 490
US-A- 4 524 294          US-A1- 2001 032 663
US-A1- 2002 043 895

## Description

### DOMAINE TECHNIQUE ET ART ANTÉRIEUR

La présente invention se rapporte à un dispositif à récupération d'énergie mécanique en énergie électrique, en particulier à un dispositif apte à transformer l'énergie libérée par des chocs d'objets venant impacter une surface déformable. Les objets dont on souhaite récupérer l'énergie d'impact peuvent être, par exemple des gouttes de pluie, le dispositif étant alors disposé dans un environnement extérieur, ou des objets rigides, de type poudre, grains... dans un dispositif de chargement par exemple.

Il est connu des dispositifs de récupération d'énergie sous forme de ruban comportant un élément en matériau piézoélectrique disposé dans un flux de liquide, par exemple de l'eau, le flux s'écoulant sensiblement parallèlement à la surface de l'élément en matériau piézoélectrique. La déformation de l'élément génère l'apparition d'une tension aux bornes d'électrodes de part et d'autres du matériau piézoélectrique.

Or ce dispositif ne permet pas une récupération optimale de l'énergie provenant d'impacts d'objets. En effet, le dispositif de l'état de la technique fonctionne par sollicitation continue du fluide de manière uniforme sur toute sa surface. Or dans le cas d'impacts d'objets, la localisation des impacts est aléatoire et discrète.

Par ailleurs ce dispositif n'est pas adapté pour être déformé de manière optimale pour des chocs transversaux à la surface de l'élément en matériau piézoélectrique.

Il est également connu du document «Optimal design of piezoelectric cantilever for a micro power generator with microbubble » 2nd Annual International IEEE-EMBS Special Topic Conference on Microtechnologies in Medicine & Biology, May 2-4, 2002, Madison, Wisconsin USA, Poster 102 ; page 424-427, une structure de conversion piézoélectrique déformée par l'appui périodique de bulles sur une structure déformable, cette structure comporte une poutre en matériau piézoélectrique encastrée à une première extrémité et comportant à une deuxième extrémité une plaque destinée à recevoir des impacts. Cette structure n'est efficace que si l'objet impactant vient déformer la structure à un endroit précis. Si les bulles viennent impacter la poutre directement, la quantité de charges produite est très faible.

Par ailleurs, les zones de récupération d'énergie formées par la poutre elle-même et la zone d'impact sont physiquement séparées. Ainsi au vu de la surface totale du système, la zone efficace est relativement réduite.

C'est par conséquent un but de la présente invention d'offrir un dispositif de récupération d'énergie provenant de l'impact d'objets sur une membrane dont la récupération d'énergie est peu dépendante du lieu d'impact des objets sur la membrane. Un dispositif connu est divulgué US 4 404 490.

### EXPOSÉ DE L'INVENTION

Le but précédemment énoncé est atteint par un dispositif comportant un élément en matériau apte à générer une tension électrique sous l'application d'une contrainte mécanique, suspendu selon sa plus grande dimension et recevant directement les impacts des objets dont on veut convertir l'énergie mécanique, l'élément comporte de part et d'autre de sa surface des électrodes s'étendant le long de sa plus grande dimension.

En d'autres termes, le dispositif est tel que le matériau transducteur est sollicité directement et les électrodes sont réparties sur toute la longueur du matériau. Cela permet de réduire l'influence de la localisation géographique des impacts sur la membrane. Ainsi, on atteint un bon rendement de conversion sur toute la surface du matériau, la quantité d'énergie récupérée est alors sensiblement la même quel que soit le lieu d'impact sur la membrane.

Grâce à la présente invention, on augmente l'efficacité spatiale du dispositif de récupération et on réduit très sensiblement la sensibilité de la récupération d'énergie à la zone sollicitée mécaniquement par l'impact d'un objet ou l'action d'un fluide.

Les structures de conversion proposées permettent donc de récupérer de l'énergie d'objets venant impacter de manière uniforme toute la surface du système. Il n'y a alors plus de séparation physique entre la zone d'impact et la zone de conversion et de récupération d'énergie formée par le matériau transducteur d'énergie mécanique en énergie électrique et les électrodes associées. Grâce à la présente invention, nous pouvons augmenter l'efficacité de la récupération d'énergie pour des sollicitations de répartition spatiale aléatoire comme peut l'être par exemple l'impact de gouttes de pluie, de gouttes provenant de systèmes d'aspersion, l'impact de particules solides lors de tamisages ou de transferts pour stockage ou utilisation quelconques.

On prévoit de réaliser des membranes, dans lesquelles le matériau transducteur est recouvert partiellement par les électrodes. Les électrodes ne sont alors plus intégralement continues en largeur (c'est-à-dire de même géométrie que la membrane) mais scindées pour former des rubans de largeur du même ordre de grandeur que celle des objets lors de l'impact, ce qui permet d'optimiser la récupération d'énergie : de cette façon on maximise la variation de déformation et de contrainte moyenne sous les électrodes en évitant des dissipations électriques dans les zones non sollicitées mécaniquement.

On prévoit également une membrane ajourée pour faciliter l'évacuation des objets ayant impacté la membrane. Dans ce mode de réalisation, la membrane peut être formée par des bandes discrètes, juxtaposées parallèlement.

Le dispositif de récupération d'énergie peut également servir pour alimenter un capteur associé ou intégré, i.e. le capteur étant formé par la membrane elle-même.

La présente invention a alors principalement pour objet un dispositif de conversion d'énergie mécanique d'impacts d'objets en énergie électrique comportant un bâti, une membrane suspendue sur ledit bâti par au moins une première et une deuxième extrémité longitudinale, ladite membrane étant destinée à être impactée par lesdits objets dans une direction sensiblement transversale à un plan moyen de la membrane, ladite membrane comportant une âme en matériau transducteur d'énergie mécanique en énergie électrique s'étendant de la première extrémité longitudinale à la deuxième extrémité longitudinale, et au moins une électrode sur une première face de l'âme et au moins une électrode sur une deuxième face de l'âme, lesdites électrodes s'étendant de la première à la deuxième extrémité longitudinale, et se recouvrant au moins partiellement. Le dispositif comporte une pluralité d'électrodes sur la première face de l'âme et une pluralité d'électrodes sur la deuxième face de l'âme, chaque pluralité d'électrodes comportant des lames discrètes juxtaposées s'étendant de la première extrémité longitudinale de la membrane à la deuxième extrémité longitudinale de la membrane, la pluralité d'électrodes sur la première face et la pluralité d'électrodes sur la deuxième face se recouvrant au moins partiellement. La quantité d'énergie ainsi récupérée est encore augmentée. L'âme comporte des lumières s'étendant entre les lames d'électrodes.

Ces lumières s'étendent longitudinalement de la première à la deuxième extrémité longitudinale de l'âme de manière à définir une membrane sous forme de bandes suspendues juxtaposées. La membrane, plus particulièrement les bandes, étant de faible largeur, celles-ci sont plus facilement déformables pour un même impact, ce qui permet d'augmenter la quantité d'énergie convertie. La largeur des lames est par exemple sensiblement égale à celle des bandes. La longueur des lames est choisie d'un ordre de longueur plus grand que sa largeur.

La largeur des électrodes sous forme de lame est avantageusement supérieure à la taille des objets destinés à impacter la membrane.

Il peut être prévu que la membrane ne soit soumise en l'absence d'impact à aucune tension mécanique, dans le cas de chocs aléatoires, ainsi elle subit une forte variation de déformation.

Il peut être prévu que la membrane soit soumise à une tension mécanique déterminée en l'absence d'impact de manière à ce que la fréquence de résonance de la membrane coïncide avec la fréquence des impacts, dans le cas de chocs répétitifs à fréquence régulière, ce qui permet d'augmenter davantage la quantité d'énergie mécanique convertie en énergie électrique.

Le matériau transducteur de l'âme peut par exemple être un matériau piézoélectrique ou un matériau électroactif.

Le dispositif selon la présente invention peut également comporter un dispositif de conversion de l'énergie solaire en énergie électrique comportant des cellules photovoltaïques, la membrane étant réalisée en matériaux transparent à la lumière, les cellules photovoltaïques étant disposées en aval de la membrane par rapport à la direction de déplacement des objets.

La présente invention a également pour objet un système comportant un dispositif de conversion selon la présente invention, et un capteur d'une grandeur physique, ledit capteur étant au moins partiellement alimenté par le dispositif de conversion

Dans ce système, la membrane peut former la zone sensible du capteur, permettant d'obtenir une information sur les objets impactant ladite membrane.

## BRÈVE DESCRIPTION DES DESSINS

La présente invention sera mieux comprise à l'aide de la description qui va suivre et des dessins annexés sur lesquels :

- la figure 1 est une représentation schématique en coupe longitudinale d'un premier mode de réalisation d'un dispositif de récupération d'énergie,
- la figure 2 est une courbe représentant l'évolution de l'énergie récupérée en fonction de la zone d'impact sur la membrane du dispositif de récupération d'énergie de la figure 1,
- la figure 3 est une vue en perspective d'un deuxième mode de réalisation de la membrane du dispositif de récupération d'énergie,
- la figure 4 est une vue en perspective d'un mode de réalisation de la membrane du dispositif selon la présente invention,
- la figure 5 est une courbe représentant l'évolution de l'énergie récupérée en fonction de la largeur d'un ruban formant la membrane de la figure 4, ce ruban ayant une longueur de 10 cm et une épaisseur de matériau transducteur PVDF DE 25 $\mu$m,
- la figure 6 est une représentation d'un enregistrement de la tension récupérée aux bornes des électrodes recouvrant un ruban de PVDF de 25 $\mu$m d'épaisseur et de 3 mm de large sur une longueur de 10 cm lors de l'impact d'une goutte de pluie de diamètre de 1 mm ayant une vitesse de 3 mm/seconde,
- la figure 7 est une représentation schématique d'une variante du premier mode de réalisation d'une membrane d'un dispositif de récupération d'énergie,
- la figure 8 est une représentation schématique en coupe longitudinale d'un système de récupération d'énergie hybride selon la présente invention intégrant le dispositif représenté sur la figure 1 et des cellules photovoltaïques.

## EXPOSÉ DÉTAILLÉ DE MODES DE RÉALISATION PARTICULIERS

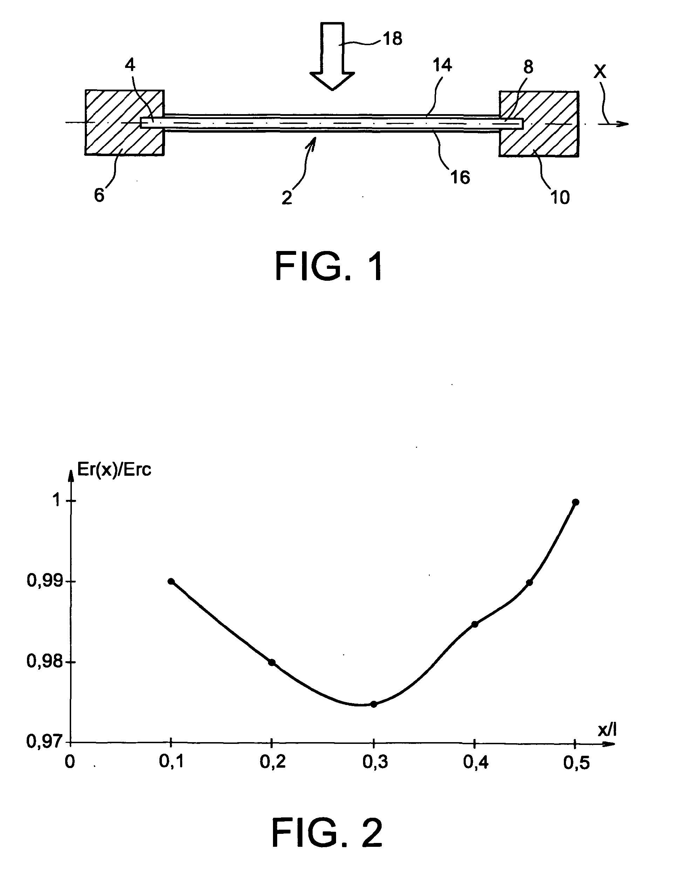

Sur la figure 1, on peut voir un détail de réalisation d'un dispositif de récupération d'énergie comportant une membrane 2 de dimension longitudinale 1 et suspendue par une première extrémité longitudinale 4 à un support 6 et à une deuxième extrémité longitudinale 8 à un support 10.

Les supports 6 et 10 font partie d'un châssis rigide du dispositif.

La membrane 2 comporte une âme 12 en matériau transducteur d'énergie mécanique en énergie électrique, une électrode 14 disposée sur sa surface supérieure et une deuxième électrode 16 disposée sur sa surface inférieure. Les termes « inférieure » et « supérieure » sont utilisés en relation avec la figure 1 et ne sont en aucun cas limitatifs, la membrane pouvant avoir une position autre qu'horizontale.

Les électrodes 14 et 16 sont disposées au moins partiellement à l'aplomb l'une de l'autre de par et d'autre de l'âme 12.

La membrane 2 s'étend le long d'un axe X.

La flèche 18 symbolise le sens de déplacement des objets destinés à impacter la membrane 2.

Les première et deuxième électrodes 14, 16 s'étendent sur toute la longueur de la membrane 2 et recouvrent donc l'âme 12 en matériau transducteur sur toute sa longueur.

Ainsi la probabilité que des objets impactant la membrane 2 viennent en contact avec l'électrode 14 est augmentée par rapport aux dispositifs de l'état de la technique.

La membrane 2 peut être de forme carrée, rectangulaire ou toute forme adaptée et maintenue au moins par deux de ces extrémités suivant sa plus grande dimension. Il n'est pas nécessaire que cette membrane soit tendue entre les deux supports 6, 10.

Les électrodes 14 et 16 conductrices peuvent être réalisées, par exemple par dépôt ou pulvérisation cathodique de quelques nanomètres d'épaisseur d'un matériau conducteur tel que, par exemple le cuivre, le nickel, ou la poudre de carbone. Ces électrodes limitent alors différentes zones de génération électrique sur la surface de la membrane 2.

De manière avantageuse, il est préférable de réaliser des membranes de forme allongée et ayant une faible épaisseur afin de maximiser le transfert d'énergie lors de l'impact d'un objet sur la structure.

Dans le cas particulier d'une conversion piézoélectrique pour une géométrie de type membrane, la formule suivante s'applique :

$$U_{\acute{e}lec} = \frac{1}{2}\frac{k^2}{Y}\Delta\sigma_{moy}^2 = \frac{1}{2}k^2 Y \Delta\varepsilon_{moy}^2$$

$Y$ étant le module d'Young du matériau piézoélectrique,
$k^2$ étant le coefficient de couplage électromécanique du matériau piézoélectrique,
$\Delta\sigma_{moy}$ étant la variation de contrainte moyenne dans

le matériau, et
$\Delta\varepsilon_{moy}$ étant la variation de déformation moyenne dans le matériau.

Il apparaît donc, pour maximiser la tension électrique aux bornes des électrodes 14, 16 et donc le transfert d'énergie, qu'il est préférable de maximiser la variation de contrainte moyenne et la variation de déformation moyenne de la membrane. Ceci est obtenu avec un système pouvant se déformer sur une grande amplitude, i.e. avec un système long et de faible épaisseur, ce qui permet d'obtenir localement des variations de contrainte moyenne importante.

Par ailleurs pour maximiser la récupération d'énergie sur toute la longueur de la membrane, quelle que soit la position axiale de l'impact sur la membrane, la dimension longitudinale des électrodes 14 et 16 est prévue sensiblement égale à celle de la membrane en particulier du matériau transducteur.

Dans la suite, on considèrera x la coordonnée d'une zone d'impact suivant l'axe longitudinal X en partant du support 6.

Sur la figure 2, on peut voir la variation du rapport de l'énergie récupérée Er(x) avec un impact ayant eu lieu en un point de coordonnée x sur l'énergie récupérée Erc avec un impact ayant eu lieu au centre de la membrane en fonction du rapport x sur la longueur totale 1 de la membrane. Cette courbe a été tracée pour une membrane de 10 cm de long, de 10 cm de large et de 25 $\mu$m d'épaisseur l'objet venant impacter la membrane étant une goutte d'eau d'1 mm de diamètre se déplaçant à 3 m/seconde.

On constate que le rapport de l'énergie récupéré en x sur l'énergie récupérée au centre de la membrane varie très peu en fonction de x, en effet ce rapport varie entre 0,975 et 1. Ainsi on obtient un dispositif de conversion d'énergie mécanique en énergie électrique, dont l'efficacité de récupération est très peu dépendante de la position de l'impact sur toute la surface de la membrane.

L'âme 12 de la membrane 2 peut être réalisée en matériau piézoélectrique massif tel que le PZT (Titano-Zirconaite de Plomb) ou polymères comme le PVDF (polyfluorure de vinylidène), ou à l'aide de polymères électroactifs comme par exemple un polymère diélectrique Acrylic VHB 4910 ® de la société 3M.

Le choix du matériau et le choix de son épaisseur dépendent des sollicitations mécaniques appliquées au système : pour des impacts de gouttes d'eau, dont le diamètre est compris entre 1 et 5 mm, une membrane en PVDF ayant une épaisseur d'une dizaine de microns peut être sélectionnée, celle-ci va pouvoir se déformer de manière importante suite aux impacts des gouttes.

Pour des objets plus volumineux et plus lourds, par exemple des grains de céréales, ou des particules rocheuses, on peut utiliser un film PVDF plus épais (de l'ordre de quelques centaines de micron) ou un élément mécaniquement plus rigide comme le PZT ou un polymère électroactif épais de type diélectrique (épaisseur supérieure à 100 μm-1 mm).

De même, le milieu dans lequel le dispositif est placé peut être déterminant pour le choix du matériau transducteur.

Dans le cas d'un milieu humide, l'optimum en terme de production d'énergie et de résistance mécanique peut être obtenu avec les matériaux électroactifs de type IPMC. Par ailleurs, le choix entre matériaux piézoélectriques ou électroactifs peut se faire également, par exemple selon le domaine des fréquences d'excitation. Par exemple, pour des fréquences d'excitation supérieures au kHz, les matériaux piézoélectriques sont particulièrement adaptés, par contre pour des fréquences d'excitation inférieures au kHz, les matériaux électroactifs semblent plus adéquats.

D'une manière générale, le choix est généralement conditionné par un optimum entre l'énergie récupérée, pour laquelle on cherche en générale à obtenir des déformations importantes, donc à avoir des systèmes de faible épaisseur, et la résistance mécanique qui impose une épaisseur minimum afin de garantir la solidité et la durée de vie du dispositif de récupération d'énergie.

En outre, comme il a été mentionné précédemment il n'est pas nécessaire que la membrane soit suspendue de manière tendue. Ceci est particulièrement avantageux dans le cas de chocs aléatoires, tels ceux des gouttes de pluie ou de grains solides quelconques. Il peut alors être prévu qu'à vide, aucune tension mécanique ne soit appliquée à la membrane, ainsi la membrane vibrante subira à chaque choc une forte variation de déformation, maximisant la quantité d'énergie mécanique pouvant être convertie en énergie électrique.

Dans le cas de chocs répétitifs à fréquence régulière, au contraire il peut être avantageux de suspendre la membrane sous tension. La membrane est alors dimensionnée et/ou une tension mécanique à laquelle elle est soumise à vide est choisie afin que la fréquence de résonance de la membrane coïncide avec la fréquence des impacts, ce qui permettra d'augmenter la quantité d'énergie mécanique convertie en énergie électrique.

La tension mécanique peut être réglée en prévoyant des supports 6, 10 montés sur des rails de manière à pouvoir les écarter l'un de l'autre.

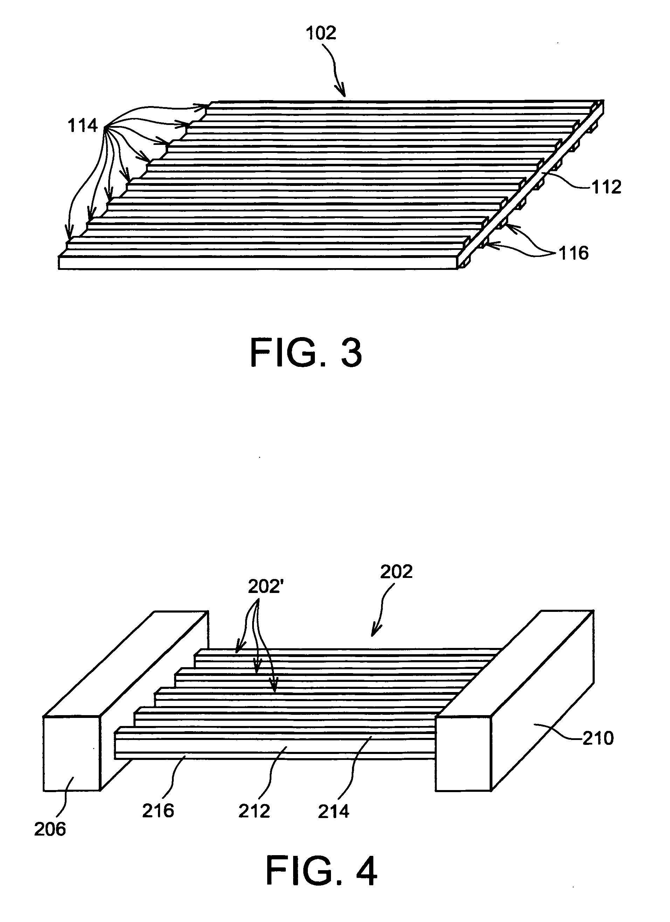

Sur la figure 3, on peut voir un deuxième mode de réalisation d'une membrane pour dispositif de récupération d'énergie d'impact, ce mode de réalisation est particulièrement avantageux puisqu'il permet d'optimiser la quantité d'énergie récupérée.

La membrane 102 représentée sur la figure 3 comporte une âme 112 en matériau transducteur d'énergie mécanique en énergie électrique, sur laquelle sont disposées des électrodes 114, 116 s'étendant sur toute la longueur des faces supérieure et inférieure de l'âme 112 respectivement.

Selon ce deuxième mode de réalisation, la membrane comporte plusieurs électrodes 114 disposées sur la surface supérieure ce l'âme 112 et plusieurs électrodes 116 disposées sur la surface inférieure de la membrane 102.

Chaque électrode 114 est disposée au moins partiellement à l'aplomb d'une électrode 116.

Ces électrodes 114, 116 forment des bandes parallèles réparties sur toute la largeur de l'âme 112, les électrodes 116 étant disposées à l'aplomb des électrodes 114. Dans le premier mode de réalisation, les électrodes 14, 16 forment une couche continue sur chacune des faces de l'âme 12 respectivement.

Cette répartition discrète des électrodes 114, 116 permet d'optimiser la récupération d'énergie sur toute la surface de la membrane 102 et ceci en limitant le déplacement des charges et leur répartition symétrique.

En effet, lorsqu'un objet vient impacter la surface supérieure de la membrane 2, l'âme 12 est déformée, générant l'apparition d'une tension dans le matériau transducteur du fait de l'asymétrie de la répartition des charges. L'énergie générée est alors stockée dans des moyens de stockages électriques, type batterie.

Dans le cas des électrodes 14, 16 représentées sur la figure 1 recouvrant de manière continue toute la surface supérieure et toute la surface inférieure de l'âme 12, les charges peuvent se déplacer dans l'âme 12 par l'intermédiaire des électrodes 12, 14. Par contre dans le cas d'une répartition discrète des électrodes 114, 116 sur la surface supérieure de l'âme et la surface inférieure de l'âme 12, le déplacement des charges est limité et la quantité d'énergie récupérée est augmentée.

Les inventeurs ont alors remarqué que, même si la quantité d'énergie potentiellement récupérable est inférieure à celle du dispositif de la figure 1 avec des électrodes 14, 16 continues, la quantité d'énergie effectivement récupérée avec le dispositif de la figure 3 est supérieure.

La largeur des électrodes est choisie de manière à être supérieure à l'ordre de grandeur de la taille des objets venant impacter la surface de la membrane 2. Par exemple dans le cas de gouttes d'eau de diamètre de 1 mm et dont l'impact a un diamètre de 4 mm, la largeur des électrodes est supérieure à 4 mm.

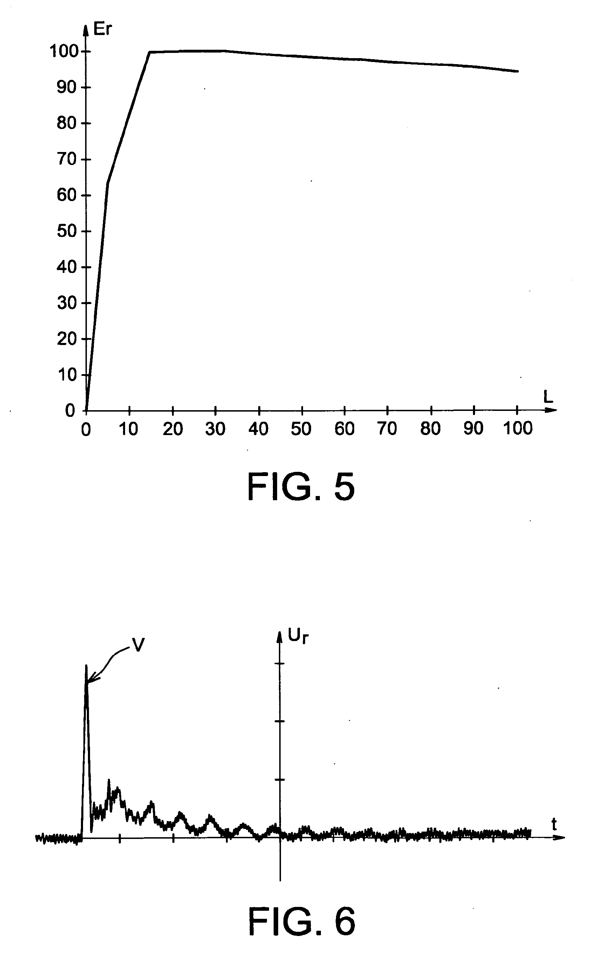

Sur la figure 5, est représenté l'évolution de l'énergie électrique récupérée Er en fonction de la largeur L des électrodes en millimètre.

L'élément transducteur a une longueur de 10 cm, une épaisseur de 25 μm, l'âme 212 est réalisée en PVDF et recouverte de part et d'autre d'électrodes avec une couche de nickel de quelques nanomètres d'épaisseur qui ne perturbent pas le comportement mécanique de la membrane. L'objet venant impacter la surface de cet élément est une goutte de pluie de diamètre de 1 mm dont le diamètre lors de l'impact peut s'étendre jusqu'à 4 mm. On constate à la lecture de ce graphique, que la largeur d'électrode de 10 mm permet de récupérer le maximum de l'énergie transmise lors de l'impact bien qu'une électrode plus large puisse apporter des énergies équivalentes.

Mais dans ce cas, d'un part l'énergie dissipée par une électrode recouvrant toute l'âme sera plus importante, donc présentera un rendement global plus faible et d'autre part, la forme sous laquelle l'énergie est récupérée dans le cas d'électrodes étroites, est plus adaptée aux circuits électroniques de gestion et de récupération de cette énergie.

Par exemple, pour une âme en matériau piézoélectrique, une lame étroite permet d'obtenir des tensions récupérées plus élevées pour une énergie donnée, ce qui limitera les pertes lors du traitement du signal, notamment lors de l'étape de redressement pour convertir le signal alternatif en signal continu.

Sur la figure 4, on peut voir un mode de réalisation d'une membrane de récupération d'énergie d'impact.

La membrane 202 est, dans ce mode de réalisation, formée par une pluralité d'éléments 202' discrets disposés parallèlement les uns par rapport aux autres et fixés à chacune de leurs extrémités longitudinales à des supports 206, 208.

Chaque élément discret 202' comporte une âme 212 en matériau transducteur recouvert de part et d'autre par des électrodes 214, 216 s'étendant sur toute la longueur de l'âme 212.

La largeur de ces éléments 202' formant des bandes ou lames est sensiblement du même ordre de grandeur que le diamètre de l'objet dont on souhaite récupérer l'énergie d'impact.

Selon ce mode de réalisation, on rend indépendant mécaniquement chacun des éléments transducteurs. La déformation de chacun des éléments est augmentée par rapport aux modes de réalisation représentés sur les figures 1 et 3, puisque la contrainte impliquée par l'impact de l'objet sur un élément 202' n'est pas « amortie » par une liaison mécanique avec les autres éléments 202'.

Dans le cas des dispositifs des figures 1 et 3, lorsqu'un objet vient impacter la surface de la membrane 2, 102, la contrainte appliquée par l'objet, qui est orientée sensiblement perpendiculairement à la surface de la membrane 202, provoque une déformation à la fois dans la direction perpendiculaire à la membrane, mais également dans une direction parallèle à la surface de la membrane. La déformation totale est d'autant plus réduite que l'énergie nécessaire à la déformation dans le plan de la membrane est importante. Dans le cas d'éléments discrets 202', puisque chaque élément discret 202' s'étend très peu de manière latérale, l'énergie nécessaire à sa déformation est très faible. Par conséquent la déformation dans une direction perpendiculaire à la membrane, plus particulièrement à chacun des éléments discrets 202' est plus importante, et par voie de conséquence l'énergie électrique récupérée par conversion de l'énergie mécanique est plus importante.

Le dispositif de la figure 4 présente également l'avantage de permettre une évacuation des objets venant impacter la membrane. En effet, ceux-ci passent à travers les espaces séparant les éléments discrets 202', la largeur de ces espaces étant choisie en fonction de la dimension des objets venant impacter la membrane 202.

Nous allons maintenant donner un exemple de dimensionnement d'un dispositif selon la figure 4.

Dans le cas où le dispositif est appliqué à la récupération d'énergie d'impact de gouttes d'un liquide, par exemple de l'eau ou autre, le dispositif peut être dimensionné de la manière suivante :

Le dispositif de conversion comporte un ensemble de lames, encastrées à chacune de leurs extrémités et réparties de manière uniforme. Ces lames sont formées d'un matériau convertisseur d'énergie mécanique en énergie électrique, par exemple un polymère piézoélectrique (type PVDF) ou un polymère électroactif. Chaque lame est recouverte d'une électrode inférieure et d'une électrode supérieure, recouvrant le polymère, ces électrodes s'étendant sur toute la longueur des lames. Les électrodes supérieures sont avantageusement réalisées de manière continue, par exemple d'un seul tenant entre les extrémités longitudinales des lames ancrées de manière à assurer la connexion électrique entre toutes les électrodes supérieures. De même pour les électrodes inférieures, elles sont avantageusement réalisées d'un seul tenant. Ce mode particulier de réalisation permet de simplifier la réalisation des connexions électriques, puisque deux connexions pour chaque ensemble d'électrodes suffisent.

La largeur des lames est déterminée en fonction de la taille des objets impactant les lames, par exemple dans le cas de gouttes, la largeur des lames est de l'ordre de grandeur du diamètre de la goutte étalée après impact. Dans le cas d'une goutte de pluie de 1 mm de diamètre, le diamètre après étalement est de 4 mm, par conséquent la largeur des lames est choisie au moins égale au diamètre après étalement, par exemple de l'ordre de 4 mm.

-Par ailleurs, la longueur des lames est choisie au moins d'un ordre de grandeur plus grand que sa largeur.

On choisit en outre un espacement entre les lames de telle sorte qu'il soit au plus égal à celui des gouttes d'eau avant impact, ainsi même dans le cas des gouttes passant entre les lames, celles-ci impactent les lames et une partie de leur énergie est récupérée. Par exemple, l'espacement entre les lames est choisi de l'ordre du diamètre des gouttes avant impact.

Dans le cas de la récupération d'énergie de gouttes de pluie de 1 mm, on peut donc réaliser un dispositif dont les lames sont en PVDF de 25 $\mu$m d'épaisseur, de 4 mm de largeur et de 10 cm de longueur, ces lames étant espacées de 1 mm.

Il est bien entendu qu'une membrane portant des lumières s'étendant sur toute ou partie de la longueur de la membrane entre les électrodes ne sort pas du cadre de la présente invention.

On peut également envisager d'incliner la surface de la membrane pour faciliter l'évacuation par gravité des objets venant impacter la surface de la membrane.

Sur la figure 6, on peut voir un exemple de tension récupérée Ur en fonction du temps t aux bornes d'une membrane de 10 cm de long, de 3 mm de large et de 25 μm d'épaisseur dont l'âme est en PVDF, l'objet venant impacter étant une goutte de pluie de diamètre 1 mm et ayant une vitesse de 3 mm/seconde avant l'impact. L'échelle pour cet enregistrement est de 40 millisecondes par division en abscisse et de 1 volt par division en ordonnée. On constate alors que la tension récupérée Ur atteint une valeur V de plusieurs volts.

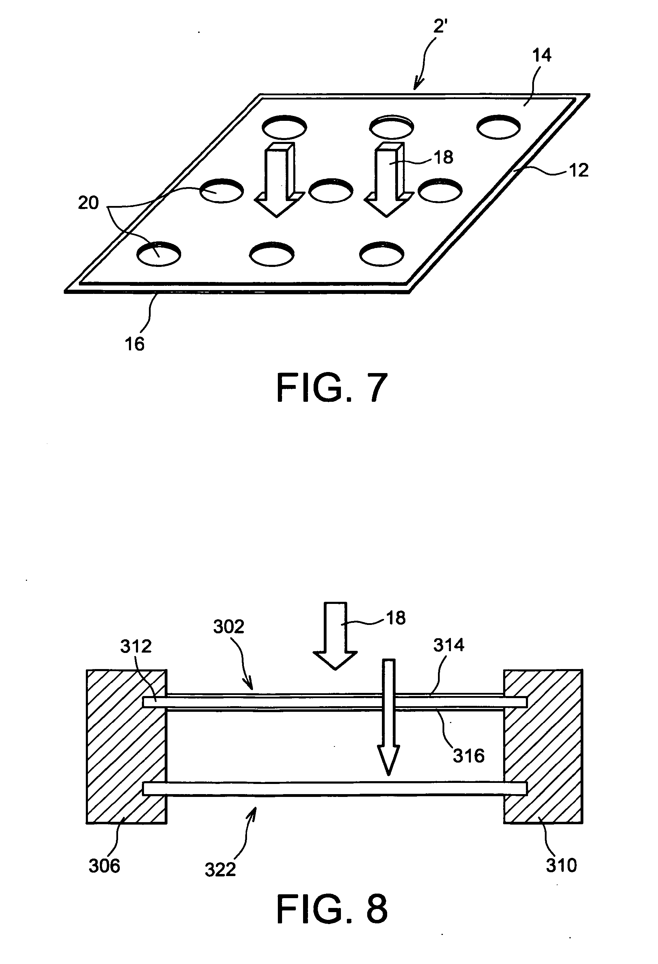

Sur la figure 7, on peut voir une variante de réalisation de la membrane 2' du dispositif de la figure 1. La membrane 2' comporte des orifices 20 pour permettre l'évacuation des objets venant impacter la surface de la membrane 2', l'électrode supérieure 14 et inférieure (non visible) s'étendent de manière continue sur l'âme 12, et sur toute la longueur de la membrane 2'.

Les orifices 20 sont représentés circulaires, mais ils peuvent avoir toute autre forme, par exemple en forme de fente.

Ces dispositifs de récupération d'énergie, dans le cas de la récupération de l'énergie des impacts des gouttes de pluie, sont donc destinés à être mis en oeuvre dans un environnement extérieur. Ils sont donc particulièrement adaptés pour être associés à un autre dispositif de récupération d'énergie, notamment un dispositif de récupération de l'énergie solaire.

Sur la figure 8, on peut voir un système de récupération d'énergie hybride permettant à la fois de récupérer l'énergie solaire au moyen de cellules photovoltaïques et de récupérer l'énergie d'impact des gouttes de pluie.

Pour cela, le dispositif hybride comporte une membrane 302 selon la présente invention transparente à la lumière suspendue entre deux supports 306, 310, le matériau transducteur étant choisi par exemple parmi les matériaux piézoélectriques ou les polymères diélectriques acryliques, et des cellules photovoltaïques 322 disposées en-dessous de la membrane transductrice dans le sens de déplacement des gouttes de pluie, sensiblement parallèlement à la membrane 302.

La membrane comporte une âme 312 et des électrodes 314, 316 de part et d'autre de l'âme et s'étendant sur toute la longueur 1 de la membrane.

Ainsi, en cas de temps ensoleillé, la lumière traverse la membrane 302 et excite les cellules photovoltaïques. En présence d'un temps pluvieux, les gouttes de pluie ou les grêlons viennent impacter la membrane.

Ce dispositif est donc particulièrement adapté pour fonctionner dans un environnement naturel sous différentes conditions météorologiques : dans des conditions pluvieuses et dans des conditions ensoleillées. La quantité d'énergie récupérée est donc augmentée.

Les dispositifs de récupération d'énergie selon la présente invention sont associés bien entendu à des moyens de stockage de cette énergie électrique (non représentés), ceux-ci étant connus de l'homme du métier, ils ne seront pas détaillés davantage dans la présente demande.

Tous les dispositifs de conversion d'énergie selon la présente invention peuvent être associés ou intégrés à un capteur alimenté au moins en partie par l'énergie électrique récupérée par conversion de l'énergie d'impact.

Ce capteur peut, en outre de manière avantageuse, utiliser la membrane telle que décrite comme système de mesure. Dans le cas de chocs, il peut s'agir d'un compteur d'impacts, de la mesure de la fréquence des impacts, de la mesure de la taille ou de la masse des particules venant impacter la membrane. Ce système peut alors permettre, par exemple dans le cas d'un dispositif de conversion d'énergie disposé dans un milieu naturel d'obtenir des informations sur la quantité de pluie tombée ou sur la fréquence des averses dans cet environnement.

Le dispositif selon la présente invention peut combiner à la fois une fonction de récupération d'énergie et une fonction capteur.

Le dispositif peut en effet permettre de récolter des informations à partir des caractéristiques de l'impact, ces informations portant sur les caractéristiques du dispositif en lui-même.

Par exemple, l'impact d'une goutte excite une fréquence de résonance de la lame ou de la membrane, fréquence de résonance qui est détectée sur le graphe de la figure 6 par la présence du pic de tension désigné par V. Cette fréquence de résonance est liée aux caractéristiques mécaniques et géométriques de la membrane, notamment à son épaisseur, à sa longueur, au type de matériau la constituant, etc. On peut donc, en mesurant une variation de cette fréquence de résonance au cours du temps, détecter par exemple une variation de l'épaisseur des lames. On peut ainsi détecter une augmentation de l'épaisseur de la membrane ou des lames par augmentation de sa raideur et ainsi en déduire la présence d'un dépôt d'un matériau sur la membrane, type calcaire ou dépôt organique, et déterminer l'épaisseur de ce dépôt. Cette information peut alors être utilisée pour prévoir un entretien du dispositif, par exemple un nettoyage ou un remplacement de la membrane.

En outre, de manière particulièrement avantageuse, la mesure de ce changement de caractéristique peut se faire de manière totalement autonome, l'énergie nécessaire à cette mesure étant directement apportée par l'impact des gouttes.

Comme décrit précédemment, les dispositifs de conversion d'énergie d'impacts selon la présente invention peuvent utiliser des objets « solides», tels que des grains de céréales ou de gravier, le dispositif de récupération est alors mis en oeuvre dans des dispositifs de remplissage ou de chargement.

Dans les modes de réalisation décrits, la membrane reçoit les impacts sur une seule de ses faces, mais un dispositif de conversion dans lequel la membrane est impactée sur ses deux faces ne sort pas du cadre de la présente invention.

On a donc bien réalisé des systèmes de récupération d'énergie mécanique de vibration de type membrane, sollicitée par l'impact d'objets, dont la géométrie du système est optimisée pour rendre la récupération d'énergie efficace sur toute la surface offerte aux sollicitations mécaniques, indépendamment de la localisation de la ou des zones mécaniquement sollicitées.

## Revendications

1. Dispositif de conversion d'énergie mécanique d'impacts aléatoires d'objets distincts en énergie électrique, comportant un bâti rigide, une membrane (202, 302) suspendue sur ledit bâti par au moins une première (4) et une deuxième (8) extrémité longitudinale, ladite membrane (202, 302) étant destinée à être impactée par lesdits objets dans une direction sensiblement transversale à un plan moyen de la membrane (202, 302), ladite membrane (202, 302) comportant une âme (212, 312) en matériau transducteur d'énergie mécanique en énergie électrique s'étendant de la première extrémité (4) longitudinale à la deuxième (8) extrémité longitudinale, ledit dispositif comportant une première pluralité d'électrodes (214) sur la première face de l'âme (212) et une deuxième pluralité d'électrodes (216) sur la deuxième face de l'âme (212), l'âme (212) comportant des lumières s'étendant longitudinalement, chaque pluralité d'électrodes (214, 216) comportant des lames discrètes juxtaposées s'étendant de la première extrémité longitudinale de la membrane (202) à la deuxième extrémité longitudinale de la membrane (202), les première et deuxième pluralités d'électrodes se recouvrant au moins partiellement, lesdites lumières de l'âme (212) s'étendant longitudinalement entre les lames d'électrodes de la première à la deuxième extrémité longitudinale de l'âme (212) de manière à définir une membrane (202) sous forme de bandes suspendues juxtaposées (202'), **caractérisé en ce que** la longueur des lames est choisie au moins d'un ordre de grandeur plus grand que sa largeur.

2. Dispositif selon la revendication 1, dans lequel les moyens pour régler la tension mécanique de la membrane comportent des supports (206, 210) des extrémités longitudinales de la membrane montés, sur des rails de manière à pouvoir les écarter l'un de l'autre.

3. Dispositif selon la revendication 1 ou 2, dans lequel la largeur (L) des électrodes (214, 216) sous forme de lame est supérieure à la taille des objets destinés à impacter la membrane (202).

4. Dispositif selon la revendication 3, destiné à récupérer l'énergie d'impact d'objets ayant un diamètre avant impact sur la membrane et un diamètre après impact sur la membrane, les lames d'électrodes présentant une largeur au moins égale au diamètre après impact et les lumières présentant une largeur au plus égale au diamètre avant impact.

5. Dispositif selon l'une des revendications 1 à 4, dans lequel la largeur (L) des lames est sensiblement égale à celle des bandes (202').

6. Dispositif selon l'une des revendications 1 à 5, dans lequel la membrane (202, 302) n'est soumise en l'absence d'impact à aucune tension mécanique.

7. Dispositif selon l'une des revendications 1 à 5, dans lequel la membrane (202, 302) est soumise à une tension mécanique déterminée en l'absence d'impact de manière à ce que la fréquence de résonance de la membrane coïncide avec la fréquence des impacts.

8. Dispositif selon l'une des revendications 1 à 7, dans lequel l'âme (212, 312) est en matériau piézoélectrique ou en matériau électroactif.

9. Dispositif selon l'une des revendications 1 à 8, dans lequel les objets destinés à impacter la membrane sont des gouttes d'eau.

10. Dispositif selon l'une des revendications 1 à 9, comportant également un dispositif de conversion de l'énergie solaire en énergie électrique comportant des cellules photovoltaïques (322), la membrane (302) étant réalisée en matériaux transparent à la lumière, les cellules photovoltaïques (322) étant disposées en aval de la membrane (302) par rapport à la direction de déplacement des objets.

11. Système comportant un dispositif de conversion selon l'une des revendications 1 à 10, et un capteur d'une grandeur physique, ledit capteur étant au moins partiellement alimenté par le dispositif de conversion.

12. Système selon la revendication 11, dans lequel la membrane forme la zone sensible du capteur, permettant d'obtenir une information sur les objets impactant ladite membrane.

13. Système selon la revendication 11 ou 12, dans lequel la membrane forme la zone sensible du capteur, le capteur étant destiné à détecter une variation d'une caractéristique de la membrane par détection d'une variation de fréquence de résonance de la membrane.

14. Utilisation du dispositif selon l'une des revendications 1 à 10 pour récupérer l'énergie des impacts de gouttes d'eau.

**Claims**

1. Device for converting mechanical energy from the random impact of discrete objects into electrical energy, comprising a rigid frame, a membrane (202, 302) suspended on said frame by at least a first (4) and second (8) longitudinal end, said membrane (202, 302) being intended to be impacted by said objects in a direction substantially transverse to a mid-plane of the membrane (202, 302), said membrane (202, 302) comprising a core (212, 3012) made from material for transducing mechanical energy into electrical energy, extending from the first longitudinal end (4) to the second longitudinal end (8), said device comprising a first plurality of electrodes (214) on the first face of the core (212) and a second plurality of electrodes (216) on the second face of the core (212), each plurality of electrodes (214, 216) comprising juxtaposed discrete blades extending from the first longitudinal end of the membrane (202) to the second longitudinal end of the membrane (202), the first and second pluralities if electrodes overlapping at least partially, the core (212) comprising apertures extending longitudinally between the electrode blades from the first longitudinal end to the second longitudinal of the core (212) so as to define a membrane (202) in the form of juxtaposed suspended strips (202'), **characterized in that** length of the blades is chosen so as to be at least an order of magnitude greater than its width.

2. Device according to claim 1, comprising wherein the means to set the mechanical tension of hte membrane comprise supports (206, 210) of the longitudinal ends of the membrane, which are mounted o, rails so as to separate the supports from each other.

3. Device according to one of claims 1 ou 2, wherein the width (L) of the electrodes (214, 216) in the form of blades is greater than the size of the objects intended to impact the membrane (202).

4. Device according to claim 3, intended to recover the impact energy of objects having a diameter before impact on the membrane and a diameter after impact on the membrane, the electrode blades having a width at least equal to the diameter after impact and the apertures having a width of no more than the diameter before impact.

5. Device according to one of claims 1 to 4, wherein the width (L) of the blades is substantially equal to that of the strips (202').

6. Device according to one of claims 1 to 5, wherein the membrane (202, 302) is not subjected to any mechanical tension in the absence of impact.

7. Device according to one of claims 1 to 5, wherein the membrane (202, 302) is subjected to a given mechanical tension in the absence of impact so that the resonant frequency of the membrane coincides with the frequency of impacts.

8. Device according to one of claims 1 to 7, wherein the core (212, 312) is made from piezoelectric material or an electroactive material.

9. Device according to one of the claims 1 to 8, wherein the objects intended to impact the membrane are drops of water.

10. Device according to one of claims 1 to 9, also comprising a device for converting solar energy into electrical energy, comprising photovoltaic cells (322), the membrane (302) being produced from material transparent to light, the photovoltaic cells (322) being disposed downstream of the membrane (302) with respect to the direction of movement of the objects.

11. System comprising a conversion device according to one of claims 1 to 10, and a sensor for a physical quantity, said sensor being at least partially powered by the conversion device.

12. System according to claim 11, wherein the membrane forming the sensitive zone of the sensor, making it possible to obtain information on the objects impacting said membrane.

13. System according to claim 11 or 12, wherein the membrane forming the sensitive zone of the sensor, the sensor being intended to detect a variation in a characteristic of the membrane by detecting a variation in resonant frequency of the membrane.

14. Use to the device according to one of claims 1 to 10 for recovering the energy from impacts of drops of water.

**Patentansprüche**

1. Vorrichtung zur Umwandlung der mechanischen Energie zufällig aufprallender einzelner Objekte in elektrische Energie, wobei die Vorrichtung einen starren Rahmen und eine Membran (202, 302) aufweist, welche über mindestens ein erstes (4) und ein zweites (8) Längsende an dem Rahmen aufgehängt ist und auf welche die Objekte in einer Richtung, die im Wesentlichen transversal zu einer Mittelebene der Membran (202,302) ist, aufprallen sollen, wobei die Membran (202,302) einen Innenabschnitt (212, 312) aufweist, der aus einem mechanische Energie in elektrische Energie umwandelnden Umwandlungsmaterial besteht und sich vom ersten Längsende (4) zum zweiten Längsende (8) erstreckt, wobei die Vorrichtung mehrere erste Elektroden (214) an der ersten Fläche des Innenabschnitts (212) und mehrere zweite Elektroden (216) an der zweiten Fläche des Innenabschnitts (212) aufweist und der Innenabschnitt (212) sich längs erstreckende Schlitze aufweist, wobei die mehreren Elektroden (214, 216) jeweils einzelne nebeneinander angeordnete Blättchen aufweisen, die sich vom ersten Längsende der Membran (202) zum zweiten Längsende der Membran (202) erstrecken, wobei sich die mehreren ersten und zweiten Elektroden zumindest teilweise überdecken und sich die Schlitze des Innenabschnitts (212) zwischen den Elektrodenblättchen in Längsrichtung vom ersten zum zweiten Längsende des Innenabschnitts (212) erstrecken, um auf diese Weise eine Membran (202) in Form von nebeneinander angeordneten aufgehängten Bändern (202') zu bilden,
**dadurch gekennzeichnet, dass** die Länge der Blättchen mindestens eine Größenordnung größer ist als ihre Breite.

2. Vorrichtung nach Anspruch 1, in welcher die Mittel zum Einstellen der mechanischen Spannung der Membran Träger (206,210) aufweisen, die die Längsenden der Membran tragen und auf Schienen montiert sind, so dass sie zueinander verschoben werden können.

3. Vorrichtung nach Anspruch 1 oder 2, in welcher die Breite (L) der blattförmigen Elektroden (214,216) größer ist als die Größe der Objekte, die auf die Membran (202) aufprallen sollen.

4. Vorrichtung nach Anspruch 3, für eine Wiedergewinnung der Aufprallenergie von Objekten, die einen Durchmesser vor Aufprall auf die Membran und einen Durchmesser nach Aufprall auf die Membran haben, wobei die Elektrodenblättchen eine Breite haben, die mindestens gleich dem Durchmesser nach Aufprall ist, und die Schlitze eine Breite haben, die höchstens gleich dem Durchmesser vor Aufprall ist.

5. Vorrichtung nach einem der Ansprüche 1 bis 4, in welcher die Breite (L) der Blättchen im Wesentlichen gleich derjenigen der Bänder (202') ist.

6. Vorrichtung nach einem der Ansprüche 1 bis 5, in welcher bei Abwesenheit eines Aufpralls die Membran (202, 302) keiner mechanischen Spannung unterworfen ist.

7. Vorrichtung nach einem der Ansprüche 1 bis 5, in welcher bei Abwesenheit eines Aufpralls die Membran (202,302) einer gegebenen mechanischen Spannung unterworfen ist, derart, dass die Resonanzfrequenz der Membran mit der Frequenz der Aufprallereignisse übereinstimmt.

8. Vorrichtung nach einem der Ansprüche 1 bis 7, in welcher der Innenabschnitt (212,312) aus einem piezoelektrischen Material oder aus einem elektroaktiven Material besteht.

9. Vorrichtung nach einem der Ansprüche 1 bis 8, in welcher die Objekte, die auf die Membran aufprallen sollen, Wassertropfen sind.

10. Vorrichtung nach einem der Ansprüche 1 bis 9, in Kombination mit einer Vorrichtung zum Umwandeln von Sonnenenergie in elektrische Energie, die Photovoltaikzellen (322) aufweist, wobei die Membran (302) aus einem lichtdurchlässigen Material besteht und die Photovoltaikzellen (322) - bezogen auf die Richtung der Objektbewegung - nach der Membran (302) angeordnet sind.

11. System, das eine Umwandlungsvorrichtung nach einem der Ansprüche 1 bis 10 und einen Sensor zum Erfassen einer physikalischen Größe aufweist, wobei der Sensor zumindest teilweise von der Umwandlungsvorrichtung elektrisch versorgt wird.

12. System nach Anspruch 11, in welchem die Membran die empfindliche Zone des Sensors bildet und erlaubt, Information über die auf die Membran aufprallenden Objekte zu gewinnen.

13. System nach Anspruch 11 oder 12, in welchem die Membran die empfindliche Zone des Sensors bildet, wobei der Sensor durch Detektion einer Änderung der Resonanzfrequenz der Membran eine Änderung einer Eigenschaft der Membran detektierten soll.

14. Verwendung der Vorrichtung nach einem der Ansprüche 1 bis 10 zum Wiedergewinnen der Energie von aufprallenden Wassertropfen.

# FIG. 1

# FIG. 2

## FIG. 3

## FIG. 4

FIG. 5

FIG. 6

## FIG. 7

## FIG. 8

## RÉFÉRENCES CITÉES DANS LA DESCRIPTION

**Documents brevets cités dans la description**

- US 4404490 A

**Littérature non-brevet citée dans la description**

- Optimal design of piezoelectric cantilever for a micro power generator with microbubble. *2nd Annual International IEEE-EMBS Special Topic Conference on Microtechnologies in Medicine & Biology,* 02 Mai 2002, 424-427